# EUROPÄISCHE PATENTANMELDUNG

(11) **EP 1 980 923 A2**
(43) Veröffentlichungstag der Anmeldung: **15.10.2008**
(21) Anmeldenummer: 08007281.2
(22) Anmeldetag: 14.04.2008
(51) Int. Cl.: G04F 10/06

(54) **Vorrichtung zum Erfassen einer Zeitlage einer Flanke**

(30) Priorität: 12.04.2007 US 907660 P
(71) Anmelder: ATMEL Germany GmbH, 74072 Heilbronn (DE)
(72) Erfinder: Schabel, Stefan, 89428 Syrgenstein (DE)
(74) Vertreter: Koch Müller Patentanwaltsgesellschaft mbH

(57) **Zusammenfassung**

Verfahren und Vorrichtung zum Erfassen einer Zeitlage einer Flanke eines Signals relativ zu einer Zeitlage einer vorbestimmten Flanke eines periodischen Signals, wobei die Flanke einen Zustandswechsel zwischen einem ersten Zustand und einem zweiten Zustand des Signals festlegt und wobei die Vorrichtung folgende Merkmale aufweist:
- ein Phasenverschiebungselement (101) zum Verschieben der Phase des Signals relativ zu der Phase des periodischen Signals um einen Phasenverschiebungswert, bei dem der Zustandswechsel zu einem durch die Zeitlage der vorbestimmten Flanke festgelegten Zeitpunkt erfassbar ist; und
- ein Erfassungselement (103) zum Erfassen der Zeitlage der Flanke relativ zu der Zeitlage der vorbestimmten Flanke auf der Basis des Phasenverschiebungswertes;

wobei das Phasenverschiebungselement (101) ein einstellbares Verzögerungselement (203) zum Verzögern des Signals um einen einstellbaren Verzögerungswert als Phasenverschiebungswert ist.

## Beschreibung

In digitalen Schaltkreisen ist es oft notwendig, die Zeitflanken unterschiedlicher Signale relativ zueinander zu erfassen. Wird ein Puls mit einer Flanke erzeugt, die bezüglich einer steigenden oder fallenden Flanke eines Taktsignals eine vorbestimmte Zeitlage, d.h. eine vorbestimmte Zeitbeziehung (beispielsweise eine Verzögerung), aufweisen soll, so ist es wichtig zu überprüfen, ob die Flanke des Pulses diese vorbestimmte Zeitlage tatsächlich aufweist.

Aus der US 2003/0006750 A1 ist ein Messbauelement zur Zeitmessung mit einer Vernier-Delay-Linie (VDL) bekannt. Hierzu sind zwei Verzögerungselemente mit festen unterschiedlichen Verzögerungszeiten vorgesehen, die jeweils rückgekoppelt einen Oszillator bilden. Aufgrund einer leicht unterschiedlichen Frequenz der beiden so gebildeten Oszillatoren kann anhand einer Zählung der Oszillationen eine Zeitdifferenz zwischen einer Flanke eines Datensignals und einer Flanke eines Taktsignals gemessen werden. Mit der Herstellung identischer Verzögerungselemente in jeder Stufe können prozessbedingte Unterschiede der Verzögerungselemente eliminiert werden.

Es ist die Aufgabe der Erfindung, eine Vorrichtung anzugeben, die eine gegenüber Prozessstreuungen möglichst unempfindliche Erfassung einer Zeitlage einer Flanke eines Signals bezüglich einer Zeitlage einer vorbestimmten Flanke eines periodischen Signals aufweist.

Diese Aufgabe wird durch die Merkmale des unabhängigen Anspruchs 1 gelöst.

Die Erfindung basiert auf der Erkenntnis, dass die Zeitlage der Flanke des Signals bezüglich der Zeitlage des als Referenz dienenden periodischen Signals durch eine Phasenverschiebung um einen Phasenverschiebungswert realisiert werden kann, bei dem zu einem durch die Zeitlage der Flanke des periodischen Signals bestimmten Zeitpunkt ein Wechsel der Zustände des Signals, beispielsweise von einem Hochpegelzustand ("high") auf einen Niedrigpegelzustand ("low") oder umgekehrt, detektiert werden kann.

Handelt es sich bei dem periodischen Signal beispielsweise um ein Taktsignal mit einer Taktrate im Bereich von z.B. 300 bis 600MHZ oder bis 800MHz, so kann beispielsweise zu einem Erfassungszeitpunkt mit der steigenden oder fallenden Flanke des Taktsignals detektiert werden, ob sich der Zustand des Signals, das beispielsweise ein Pulssignal, das periodisch sein kann, oder ein Sprungsignal sein kann, verglichen mit einem zu einem vorhergehenden Erfassungszeitpunkt erfassten Zustand des Signals geändert hat. Wurden beispielsweise zu dem vorhergehenden und dem aktuellen Erfassungszeitpunkt unterschiedliche Zustände des Signals erfasst, liegt also ein Zustandswechsel vor, so wurde die Phase der Flanke des Signals soweit in Richtung der Phase des vorbestimmten Flanke des periodischen Signals verschoben, dass auf der Basis des Phasenverzögerungswertes und ggf. der Phase des periodischen Signals, die als Referenzwert angenommen werden kann, auf die ursprüngliche Phase der Flanke relativ zu der Phase der vorbestimmten Flanke und somit auf die Zeitlage der Flanke bezüglich der Zeitlage der vorbestimmten Flanke geschlossen werden kann.

Ist hingegen auch zu dem gegenwärtigen Erfassungszeitpunkt, der durch die Zeitlage der vorbestimmten Flanke festgelegt ist, kein Zustandswechsel feststellbar, so wird die Phase des Signals beispielsweise in einer Mehrzahl von Phasenverschiebungsschritten mit jeweils einem vorbestimmten Phasenverschiebungswert (z.B. 1Grad oder 2Grad oder 10ps oder 20ps oder 30ps) so. lange verschoben, bis zu dem durch die vorbestimmte Flanke des periodischen Signals vorgegebenen Zeitpunkt der Zustandswechsel erfassbar ist. Auf der Basis der Gesamtphasenverzögerung kann direkt auf die Zeitlage der Flanke geschlossen werden.

Die Erfindung schafft eine Vorrichtung zum Erfassen einer Zeitlage einer Flanke eines Signals, beispielsweise eines Pulssignals oder eines Sprungssignals oder eines periodischen Pulssignals, relativ zu einer Zeitlage einer vorbestimmten, beispielsweise einer steigenden oder fallenden, Flanke eines periodischen Signals, das ein periodisches Taktsignal sein kann. Vorzugsweise dient das periodische Taktsignal, dabei als hochgenaue zeitliche Referenz. Vorteilhafterweise wird das Taktsignal aus der Schwingung eines Schwingquarzes abgeleitet. Vorteilhafterweise weist die Vorrichtung einen Eingang zum Empfang des periodischen Signals auf. Die Flanke des Signals legt dabei einen Zustandswechsel zwischen einem ersten Zustand und einem zweiten Zustand des Signals fest. Dabei sind die Signale vorzugsweise derart beschaffen, dass eine Differenz der Zeitlagen der Flanke und der vorbestimmten Flanke geringer als die Periodendauer des periodischen Signals ist und beispielsweise deren Bruchteil beträgt.

Bevorzugt umfasst die Vorrichtung ein Phasenverschiebungselement zum Verschieben der Phase des Signals relativ zu der Phase des periodischen Signals um einen Phasenverschiebungswert, bei dem der Zustandswechsel zu einem durch die Zeitlage der vorbestimmten Flanke festgelegten Zeitpunkt erfassbar (z.B. detektierbar) ist. Mit anderen Worten dreht das Phasenverschiebungselement die Phase des Signals in Richtung der Phase des periodischen Signals so lange, bis der Zustandswechsel beispielsweise mit der vorbestimmten Flanke erfassbar ist. Das Phasenverschiebungselement ist ein bezüglich eines Verzögerungswertes einstellbares Verzögerungselement. Das Verzögerungselement ist zum Verzögern des Signals um einen einstellbaren Verzögerungswert ausgebildet. Durch eine Einstellung wird dabei der Verzögerungswert geändert. Der Verzögerungswert bildet dabei den Phasenverschiebungswert.

Die Vorrichtung umfasst ferner ein Erfassungselement zum Erfassen der Zeitlage der Flanke relativ zu der Zeitlage der vorbestimmten Flanke auf der Basis des Phasenverschiebungswertes. Da der Phasenverschiebungswert denjenigen Phasenwert angibt, um den die Phase des Signals verschoben werden muss, bis der Zustandswechsel eintritt, kann das Erfassungselement beispielsweise direkt aus dem Phasenverschiebungswert auf die Zeitlage der Flanke schließen. Denn beim Vorliegen des Zustandswechsels in dem Zeitpunkt, in dem die vorbestimmte Flanke auftritt, kann davon ausgegangen werden, dass die Phasen der Flanken innerhalb eines Genauigkeitsbereichs, der beispielsweise durch einen kleinsten Phasenverzögerungswert bestimmt ist, übereinstimmen.

Gemäß einer bevorzugten Weiterbildung weist das Verzögerungselement Mittel zur Einstellung des Verzögerungswerts durch Steuerung in diskreten Schritten auf. Der Phasenverschiebungswert ist hierbei ein Gesamtphasenverschiebungswert, der sich aus einer Mehrzahl von diskreten Phasenverschiebungswerten zusammensetzt. Die Phasendrehung in den diskreten Schritten ist vorteilhafterweise iterativ.

Diese Weiterbildung vorteilhaft ausgestaltend weist das Verzögerungselement als Mittel schaltbare Kapazitäten auf. Die Kapazitäten sind vorteilhafterweise integrierte Kondensatoren, wie MIM-Kondensatoren oder MOS-Kondensatoren. Alternativ sind die Kapazitäten Gate-Kapazitäten von MOS-Feldeffekttransistoren. Die Feldeffekttransistoren können beispielsweise als hintereinander geschaltete inverter das Verzögerungselement bilden. Zur Einstellung weist das Verzögerungselement als Mittel weiterhin Schalter, insbesondere Schalttransistoren auf, die für ein Schalten verschiedener Kapazitätswerte für die Einstellung des Verzögerungswertes verbunden sind.

In einer anderen vorteilhaften Weiterbildung ist das Verzögerungselement als Phasenverschiebungselement ausgebildet, die Phase des Signals in einer Mehrzahl von diskreten Schritten mit jeweils einem pro Schritt vorbestimmten Verzögerungswert als Phasenverschiebungswert so lange zu verschieben, bis in einem durch die Zeitlage der vorbestimmten Flanke des periodischen Signals festgelegten Zeitpunkt der Zustandswechsel erfassbar ist.

Die Verzögerung wird beispielsweise in Schritten von 20ps realisiert. Das Phasenverschiebungselement ist daher ein digitales oder analoges einstellbares Verzögerungselement zum Verzögern des Signals um einen Verzögerungswert. Die Erfassungselement kann beispielsweise auf der Basis des (Gesamt-) Verzögerungswerts, bei dem der Zustandswechsel eintritt, und ggf. auf der Basis der Periodendauer der Periode des periodischen Signals, durch eine Differenzbildung die Zeitlage der Flanke bezüglich der Zeitlage der vorbestimmten Flanke erfassen.

Gemäß einer Ausführungsform ist das Phasenversaiebungselement ausgebildet, die Phase des signals in einer Mehrzahl von Phasenverschebungsschritten mit jeweils einem pro Phasenverschiebungsschritt vorbestimmten (relativen oder absoluten) Phasenverschiebungswert, beispielsweise 1Grad, 2Grad, 5Grad, 10Grad oder 10ps oder 15ps oder 20ps, zu verschieben. Das Phasenverschiebungselement kann beispielsweise die Phase des Signals in einem weiteren Phasenverschiebungsschritt um einen weiteren Phasenverschiebungswert erhöhen oder verringern, falls bei der gegenwärtigen Phase des Signals zu einem durch die vorbestimmte Flanke festgelegten Zeitpunkt kein Zustandswechsel erfassbar ist. Diese Iteration kann so lange durchgeführt werden, bis der Zustandswechsel zu einem durch die vorbestimmte Flanke festgelegten Zeitpunkt, der beispielsweise in einer weiteren Periode des periodischen Signals liegen kann, erfassbar ist.

Gemäß einer besonders bevorzugten weist die Vorrichtung ein Steuerelement auf, das zur Einstellung des Verzögerungswertes die Verzögerung des Verzögerungselemerits um einen vorbestimmten Verzögerungswert ausgebildet ist. Das Steuerelement ist ausgebildet in Abhängigkeit von einem Ausgangssignal des Erfassungselements den Verzögerungswert zu verändern, insbesondere falls das Ausgangssignal des Erfassungselements anzeigt, dass kein Zustandswechsel vorliegt.

In einer bevorzugten Ausgestaltung ist das Steuerelement zur Ermittlung und Ausgabe des Verzögerungswerts anhand der gesteuerten diskreten Schritte als erfasste Zeitlage der Flanke des Signals relativ zu der Zeitlage der vorbestimmten Flanke des periodischen Signals ausgebildet.

Gemäß, einer besonders bevorzugten Weiterbildung weist die Vorrichtung einen Timer auf, der vorzugsweise zusammen mit dem Verzögerungselement auf einem. Halbleiterchip integriert ist. Der Timer gibt ansprechend auf ein des Steuerelements, (als das Signal) ein Timersignal mit einer Timersignalflanke (als Flanke des Signals) aus. Diese legt den Zustandswechsel zwischen einem ersten und einem zweiten Zustand des Timersignals fest.

Das Steuerelement ist ausgebildet das Steuersignal zu wiederholen und den Verzögerungswert mit jeder Wiederholung zu ändern bis vom Erfassungselement ein Phasennulldurchgang als Abbruchbedingung detektierbar ist.

In einer besonders vorteilhaften Weiterbildung weist die Vorrichtung ein Analyseelement auf. Das Analyseelement ist zum Erfassen der Charakteristik des Timers auf der Basis eines Verlaufs von Verzögerungswerten in Abhängigkeit von Zeitlagen ausgebildet. Vorzugsweise ist das Analyseelement ausgebildet, eine Analyse eines Verlaufs von Phasenverschiebungswerten in Abhängigkeit von Zeitlagen durchzuführen, um beispielsweise festzustellen, ob der Verlauf monoton fallend oder monoton steigend ist.

Gemäß einer weiteren Ausführungsform ist die Vorrichtung ferner ausgebildet, eine Zeitlage einer weiteren Flanke eines weiteren Signals relativ zu einer Zeitlage einer vorbestimmten Flanke des periodischen Signals zu erfassen, wobei die weitere Flanke einen Zustandswechsel zwischen einem ersten Zustand und einem zweiten Zustand des weiteren Signals festlegt, wobei das Phasenverschiebungselement ausgebildet ist, die Phase des weiteren Signals relativ zu der Phase des periodischen Signals um einen weiteren Phasenverschiebungswert zu verschieben, bei dem der Zustandswechsel zu einem durch die Zeitlage der vorbestimmten Flanke des periodischen Signals festgelegten Zeitpunkt erfassbar ist, und wobei das Erfassungselement ausgebildet ist, die Zeitlage der Flanke des weiteren Signals relativ zu der Zeitlage der vorbestimmten Flanke auf der Basis eines weiteren Phasenverschiebungswertes zu bestimmen.

Gemäß einer weiteren Ausführungsform ist das Erfassungselement dem Phasenverschiebungselement nachgeschaltet. Vorzugsweise ist das Steuerelement dem Erfassungselement nachgeschaltet und empfängt dessen Ausgangssignale. Das Steuerelement ist vorzugsweise ausgebildet, die Phasenverschiebung des Phasenverschiebungselementes um einen vorbestimmten Phasenverschiebungswert, z.B. 1Grad, 2Grad oder 5Grad oder 10ps oder 15ps oder 20ps, zu erhöhen, falls ein Ausgangssignal des Erfassungselements anzeigt, dass kein Zustandswechsel vorliegt.

Gemäß einem weiteren Aspekt schafft die Erfindung ein Meßsystem zur Erfassung einer Charakteristik eines Timers, der ansprechend auf ein Steuersignal, das eine Zeitlage einer Flanke relativ zu einer Zeitlage einer vorbestimmten Flanke eines periodischen Signals anzeigt, ein Timersignal mit einer Timersignalflanke ausgibt, die einen Zustandswechsel zwischen einem ersten und einem zweiten Zustand des Timersignals festlegt. Gemäß einem Aspekt ist der Timer selbst kein Bestandteil des Meßsystems. Gemäß einem weiteren Aspekt ist der Timer ein Bestandteil des Meßsystems und ist mit diesem beispielsweise auf einem Chip angeordnet. Das Meßsystem ist bevorzugt vorgesehen, die Charakteristik des Timers zu erfassen oder zu überwachen.

Das Meßsystem umfasst ein Steuerelement zum Bereitstellen oder Erzeugen eines ersten Steuersignals und eines zweiten Steuersignals, wobei das erste Steuersignal eine erste Flanke mit einer ersten Zeitlage relativ zu einer Zeitlage einer vorbestimmten Flanke eines periodischen Signals anzeigt und wobei das zweite Steuersignal eine zweite Flanke mit einer zweiten Zeitlage relativ zu einer Zeitlage einer vorbestimmten Flanke des periodischen Signals anzeigt. Werden beide Signale dem zu vermessenden Timer sukzessive zugeleitet, so erzeugt dieser ansprechend auf jene jeweils ein Timersignal mit zumindest einer Timerflanke.

Das Meßsystem umfasst ferner die zuvor erläuterte Vorrichtung zum Erfassen einer Zeitlage einer Flanke, deren Phasenverschiebungselement ausgebildet ist, die Phase eines ersten Timersignals mit einer ersten Timersignalflanke relativ zu der Phase des periodischen Signals um einen ersten Phasenverschiebungswert zu verschieben, bei dem der Zustandswechsel zu einem durch die Zeitlage der vorbestimmten Flanke festgelegten Zeitpunkt erfassbar ist. Das Phasenverschiebungselement ist ferner ausgebildet, die Phase eines zweiten Timersignals mit einer zweiten Timersignalflanke relativ zu der Phase des periodischen Signals um einen zweiten Phasenverschiebungswert zu verschieben, bei dem der Zustandswechsel zu einem durch die Zeitlage der vorbestimmten Flanke festgelegten Zeitpunkt erfassbar ist. Das Erfassungselement ist ferner ausgebildet, die Zeitlage der ersten Timersignalflanke auf der Basis des ersten Phasenverschiebungswertes und die Zeitlage der zweiten Timersignalflanke auf der Basis des zweiten Phasenverschiebungswertes zu bestimmen.

Das Meßsystem umfasst ferner ein Analyseelement zum Erfassen der Charakteristik auf der Basis eines Verlaufs von Phasenverschiebungswerten in Abhängigkeit von Zeitlagen. Wird die Phasenverschiebung durch eine Zeitverzögerung realisiert, so erfasst das Analyseelement die Charakteristik auf der Basis von Zeitverzögerungswerten und (optional) auf der Basis der Periodendauer der Periode des periodischen Signals.

Gemäß einer weiteren Ausführungsform ist das Analyseelement ausgebildet, festzustellen, ob der Verlauf von Phasenverschiebungswerten in Abhängigkeit von Zeitlagen monoton ist. Ist der Verlauf monoton und bevorzugt linear, so kann daraus auf die korrekte Funktionsweise des Timers geschlossen werden.

Das Meßsystem kann ferner eine Schnittstelle aufweisen, an diese der Timer anschließbar ist. Die Schnittstelle kann ausgebildet sein, die vorstehend erwähnten Steuersignale für den Timer bereitzustellen und/oder die Timersignale zu empfangen.

Gemäß einem weiteren Aspekt schafft die Erfindung ein Verfahren zum Erfassen einer Zeitlage einer Flanke eines Signals relativ zu einer Zeitlage einer vorbestimmten Flanke eines periodischen Signals, wobei die Flanke einen Zustandswechsel zwischen einem ersten Zustand und einem zweiten Zustand des Signals festlegt. Das Verfahren umfasst bevorzugt das Verschieben der Phase des Signals relativ zu der Phase des periodischen Signals um einen Phasenverschiebungswert durch Einstellen eines Verzögerungswerts eines Verzögerungselements.Der Zustandswechsel ist zu einem durch die Zeitlage der vorbestimmten Flanke festgelegten Zeitpunkt erfassbar.

Gemäß einer weiteren Ausführungsform umfasst das Verfahren das Erfassen der Zeitlage der Flanke relativ zu der Zeitlage der vorbestimmten Flanke auf der Basis des Verzögerungswerts als Phasenverschiebungswert.

Gemäß einer vorteilhaften Weiterbildung ist vorgesehen, das Verschieben der Phase des Signals sooft wiederholt wird, bis ein Phasennulldurchgang als Abbruchbedingung vorzugsweise durch ein Erfassungselement erfasst wird.

Gemäß einem weiteren Aspekt schafft die Erfindung ein Messverfahren zur Erfassung einer Charakteristik eines Timers, der ansprechend auf ein Steuersignal, das eine Zeitlage einer Flanke relativ zu einer Zeitlage einer vorbestimmten Flanke eines periodischen Signals anzeigt, ein Timersignal mit einer Timersignalflanke ausgibt, die einen Zustandswechsel zwischen einem ersten und einem zweiten Zustand des Timersignals festlegt. Das Messverfahren umfasst bevorzugt das Bereitstellen oder Erzeugen eines ersten Steuersignals und eines zweiten Steuersignals, wobei das erste Steuersignal eine erste Flanke mit einer ersten Zeitlage relativ zu einer Zeitlage einer vorbestimmten Flanke eines periodischen Signals anzeigt und wobei das zweite Steuersignal eine zweite Flanke mit einer zweiten Zeitlage relativ zu einer Zeitlage einer vorbestimmten Flanke des periodischen Signals anzeigt. Das Messverfahren kann ferner den Schritt des Ansteuerns des Timers aufweisen, um diesem die Steuersignale zuzuleiten.

Ferner umfasst das Messverfahren die Schritte des erfindungsgemäßen Verfahrens zum Erfassen einer Zeitlage einer Flanke, wobei in dem Schritt des Verschiebens die Phase eines ersten Timersignals mit einer ersten Timersignalflanke relativ zu der Phase des periodischen Signals um einen ersten Phasenverschiebungswert verzögert wird, bei dem der Zustandswechsel zu einem durch die Zeitlage der vorbestimmten Flanke festgelegten Zeitpunkt erfassbar ist, und wobei in dem Schritt des Verschiebens ferner die Phase eines zweiten Timersignals mit einer zweiten Timersignalflanke relativ zu der Phase des periodischen Signals um einen zweiten Phasenverschiebungswert verzögert wird, bei dem der Zustandswechsel zu einem durch die Zeitlage der vorbestimmten Flanke festgelegten Zeitpunkt erfassbar ist, wobei in dem Schritt es Erfassens die Zeitlage der ersten Timersignalflanke auf der Basis des ersten Phasenverschiebungswertes und die Zeitlage der zweiten Timersignalflanke auf der Basis des zweiten Phasenverschiebungswertes bestimmt wird.

Ferner umfasst das Messverfahren den Schritt des Erfassens der Charakteristik auf der Basis eines Verlaufs von Phasenverschiebungswerten in Abhängigkeit von Zeitlagen. Falls die Phasenverschiebung durch Zeitverzögerung realisiert wird, so umfasst das Messverfahren den Schritt des Erfassens der Charakteristik auf der Basis des Verlaufs von Zeitverzögerungswerten in Abhängigkeit von Zeitlagen.

Weitere Schritte der erfindungsgemäßen Verfahren ergeben sich direkt aus der jeweiligen Funktionalität der jeweiligen Vorrichtung.

Gemäß einem weiteren Aspekt schafft die Erfindung ein Computerprogramm zum Ausführen zumindest eines der zuvor erläuterten Verfahren, wenn das Computerprogramm auf einem Rechner abläuft. Gemäß einem weiteren Aspekt schafft die Erfindung eine programmtechnisch eingerichtete Vorrichtung, die ausgebildet ist, das Computerprogramm auszuführen.

Ein weiterer Aspekt der Erfindung ist eine Verwendung eines zusammen mit einem Timer auf einem Halbleiterchip integrierten einstellbaren Verzögerungselements zur Erfassung einer Charakteristik des Timers. Das Verzögerungselement ist ausgebildet ein Signal um einen einstellbaren Verzögerungswert zu verzögern. Der Timer gibt ansprechend auf ein Steuersignal ein Timersignal mit einer Timersignalflanke aus, die einen Zustandswechsel zwischen einem ersten und einem zweiten Zustand des Timersignals festlegt.

Die zuvor beschriebenen Weiterbildungsvarianten sind sowohl einzeln als auch in Kombination besonders vorteilhaft. Dabei können sämtliche Weiterbildungsvarianten untereinander kombiniert werden. Einige mögliche Kombinationen sind in der Beschreibung der Ausführungsbeispiele der Figuren erläutert. Diese dort dargestellten Möglichkeiten von Kombinationen der Weiterbildungsvarianten sind jedoch nicht abschließend.

Weitere Ausführungsformen der Erfindung werden Bezug nehmend auf die beiliegenden Zeichnungen erläutert. Es zeigen:
- Fig. 1: ein Blockdiagramm einer Vorrichtung zur Erfassung einer Flanke;
- Fig. 2: ein Blockdiagramm eines Meßsystems;
- Fig. 3: ein Signalzeitdiagramm; und
- Fig. 4a bis 4c: Signalzeitdiagramme.

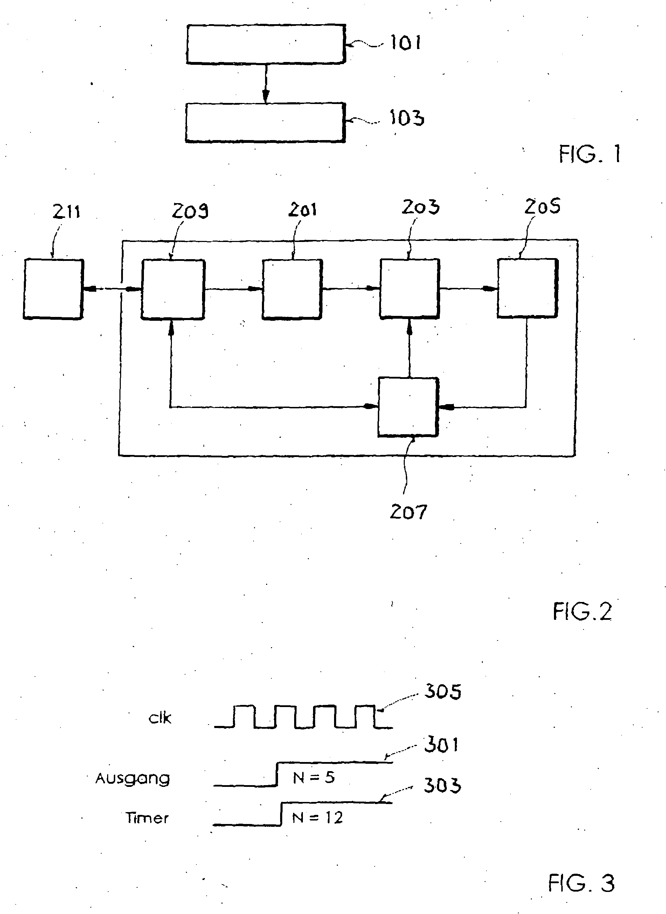

Fig. 1 zeigt ein Blockdiagramm einer Vorrichtung zum Erfassen einer Zeitlage einer Flanke eines Signals relativ zu einer Zeitlage einer vorbestimmten Flanke eines periodischen Signals. Die Vorrichtung umfasst ein Phasenverschiebungselement 101 zum Verschieben der Phase des Signals relativ zu der Phase des periodischen Signals um einen (Gesamt-)Phasenverschiebungswert, bei dem der Zustandswechsel zu einem durch die Zeitlage der vorbestimmten Flanke (zweite Zeitlage) festgelegten Zeitpunkt erfassbar ist. Das Phasenverschiebungselement 101 ist ein Verzögerungselement sein, das das Signal beispielsweise iterativ in einer Mehrzahl von Verzögerungsschritten mit einem Verzögerungswert von beispielsweise jeweils 20ps so lange verzögert, bis ein Zustandswechsel zwischen Signalzuständen durch z.B. einen Schwellwertdetektor detektierbar ist.

Ferner umfasst die Vorrichtung ein Erfassungselement 103 zum Erfassen der Zeitlage der Flanke relativ zu der Zeitlage der vorbestimmten Flanke auf der Basis des Phasenverschiebungswertes. Wird die Phase des periodischen Signals als Bezugsgröße angenommen, so kann das Erfassungselement 103 unmittelbar aus der Phasenverschiebung und der gegebenen Taktrate auf die Zeitlage der Flanke schließen.

Ein Vorteil des Ausführungsbeispiels der Fig. 1 kann darin bestehen, dass die Zeitlage der Flanke des Signals auch dann bestimmt werden kann, wenn die Periodendauer des Taktsignals länger als die Differenz der Zeitlagen der Flanke und der vorbestimmten Flanke ist. Daher kann beispielsweise bei einer messtechnischen Erfassung der Zeitlagen von Signalflanken auf den Einsatz teurer Oszillatoren mit hohen Taktraten, die sonst zur Erfassung von derart geringen Zeitdifferenzen notwendig wären, verzichtet werden.

Ein weiterer Vorteil dieses Ausführungsbeispiels kann darin bestehen, dass beispielsweise die Vermessung der Zeitlagen von Signalflanken direkt auf einem Chip erfolgen kann und nicht über Messkarten oder Tester geführt werden muss. Dadurch werden auch Signalverzerrungen oder Laufzeitverschiebungen reduziert. Ferner muss nicht zwingend eine externe Testhardware, wie z.B. ein Hochgeschwindigkeits-Abtaster oder ein Hochgeschwindigkefts-Oszilloskop, eingesetzt werden. Somit sind auch keine hochfrequenten Messungen außerhalb des Chips notwendig. Die ermittelten Werte können beispielsweise über eine serielle oder eine parallele Schnittstelle nach erfolgter Messung mit geringer Geschwindigkeit ausgelesen werden und die Messzeiten sind kurz. Die Signalverarbeitungselemente, Steuerungselemente oder Erfassungselemente können mit einem langsamen Takt, der beispielsweise durch das periodische Signal vorgegeben ist, arbeiten, weil der kritische Signalpfad über ein Verzögerungselement als Phasenverschiebungselement 101 verläuft.

Fig. 2 zeigt ein Blockdiagramm eines Meßsystems zur Erfassung einer Charakteristik eines Timers 201. Das Meßsystem umfasst eine Verzögerungseinheit 203 (Verzögerungselement), der ein Abtastelement 205 (Erfassungselement) nachgeschaltet ist. Ein Ausgang des Abtastelementes 205 ist mit einem Eingang einer Kontrolleinheit 207 (Steuerelement) verbunden, wobei ein Ausgang der Kontrolleinheit 207 mit einem Eingang der Verzögerungseinheit 203 verbunden ist. Ein weiterer Eingang der Verzögerungseinheit 203 ist mit einem Ausgang des Timers 201 verbunden bzw. verbindbar. Das Meßsystem umfasst ferner ein Interface 209, dessen Ausgang mit einem Eingang des Timers 201 verbunden ist. Ein Anschluss des Interfaces 209 ist ferner mit einem weiteren Anschluss der Kontrolleinheit 203 verbunden. Ein weiterer Anschluss des Interfaces 209 ist mit einem Tester 211, der ein externer Tester oder ein Bestandteil des Meßsystems sein kann, verbunden.

Das Meßsystem wird eingesetzt, um den (bestehenden) Timer 201, dessen. Ausgangspuls nach einstellbaren Bruchteilen 1/k der Periode eines Systemtaktes erzeugt wird, zu messen und zu bewerten, ob sich die zeitliche Auflösung des Timers linear oder monoton verhält. Hierzu wird zusätzlich, beispielsweise auf einem Chip, die Verzögerungseinheit 203 eingesetzt, die bevorzugt einstellbar ist. Ferner sind das Abtastelement 205 und die Kontrolleinheit 207 vorgesehen.

Der Timer 201, dessen Ausgangspuls (bzw. die Zeitlage des Ausgangspulses) in Bruchteilen 1/k, wobei k eine natürliche Zahl ist, der Systemtaktperiode T (clk) eingestellt werden kann, stellt die zu messende Schaltung dar. Die Verzögerungseinheit 203 hat bevorzugt eine monotone Charakteristik, wobei deren Verzögerung bevorzugt mit wenigen Picosekunden Genauigkeit einstellbar ist. Die Verzögerungseinheit 203 kann beispielsweise eine in 10ps, 15ps oder 20ps einstellbare, monoton aufgebaute Verzögerungsleitung sein, die von der Kontrolleinheit 207 (Steuereinheit), die mit dem angeschlossenen Tester 201 kommunizieren kann (z.B. über das serielle oder parallele Interface 209), angesteuert wird. Der Ausgang der Verzögerungseinheit 203 wird auf einen mit dem Systemtakt getakteten Abtaster 205 geschaltet. Das Abtastelement 205 ist vorgesehen, um das Ausgangssignal der Verzögerungseinheit 203 mit dem Systemtakt abzutasten.

Ein Ausgangspuls des Timers 201, dessen Zeitlage in Bruchteilen der Systemperiode einstellbar ist, wird durch die Verzögerungseinheit 203 geführt. Die Kontrolleinheit 207 sucht nach derjenigen Einstellung der Verzögerungseinheit 203 (Verzögerungswert), die die Phase des Ausgangspulses des Timers 201 wieder auf den Takt des Abtasters 205 verschiebt. Dabei bewirken unterschiedliche Einstellungen des Timers 201 unterschiedliche, ermittelte Verzögerungen. Diese. Ergebnisse können zur Bewertung der monotonen/linearen Kennlinie des Timers 201.

Dadurch wird erreicht, dass zur Messung der Charakteristik des Timers 201 der kritische Signalpfad nicht auf dem Chip über eine Messkarte oder einen Tester geführt werden muss. Ferner ist keine zusätzliche, externe Hardware notwendig. Die Messzeiten sind kurz, wobei auf hochfrequente Messungen verzichtet werden kann. Die Berechnung der Kennlinie des Timers und/oder die Bestimmung, ob die zeitliche Auflösung monoton oder linear ist, kann mit Hilfe einer Testersoftware, wenn diese auf einem Rechner abläuft, ermittelt werden.

Fig. 3 zeigt beispielhaft Zeitlagen eines Timerausgangssignals 301 für N=5 und eines Timerausgangssignals 303 für N=12 relativ zu einem Taktsignal 305 (clk) mit k=40.

Zwecks Messung wird der Timer 201, dessen Ausgangspuls z.B. periodisch ist und z.B. über die einstellbare Verzögerungsleitung 203 geführt wird, beispielsweise auf 1/40 (etwa 9Grad) eingestellt,. Die Verzögerungsleitung 203 wird derart realisiert, dass sie mit einer Schrittweite von etwa 20ps einstellbar ist und sich monoton verhält, was beispielsweise durch das Zuschalten einer zusätzlichen Kapazität für jeden digitalen Einstellwert (Verzögerungswert) realisiert werden kann, wobei größere digitale Werte größere Verzögerungen bewirken.

Der Ausgang der Verzögerungsleitung wird von dem mit dem Systemtakt laufenden Abtasterelement 205 übernommen, wobei im statischen Fall je nach Einstellung des Timers 201 und der Verzögerungsleitung 203 entweder ein dauerhafter High- oder Low-Pegel ermittelt wird. Der digitale Verzögerungswert D(i), wobei i den Schrittindex bezeichnet, startet bei null (i=1), wobei der durch den Abtaster 205 abgetastete Wert gespeichert wird.

Der digitale Verzögerungswert D(i) für die Verzögerungseinheit 203 wird so lange um z.B. jeweils einen Schritt erhöht, bis der abgetastete Wert z.B. "low" ist und der vorherige gespeicherte Wert "high" war, also bis ein Zustandswechsel eintritt. Der digitale Verzögerungswert der Verzögerungseinheit 203 wird von dem Tester 211 ausgelesen.

Der Timer 211 wird nun z.B. auf 2/40 (N=2, k=40) eingestellt (etwa 18Grad) und die obigen Schritte werden wiederholt. Dabei wird z.B. der digitale Verzögerungswert D(2) der Verzögerungseinheit 203 ausgelesen. Da der Timer 211 sich um 1/40 gegenüber D(1) in positiver Richtung geändert haben muss, muss die Verzögerung geringer sein, um den verzögerten Ausgangspuls mit dem Abtasttakt zu überlappen. D(2) muss also kleiner als D(1) sein (differentielle Nichtlinearität). Auf diese Weise kann der gesamte Wertebereich des Timers 211 eingestellt und vermessen werden. Die Bewertung und Analyse kann mittels einer auf einem Computer ablaufenden Testersoftware durchgeführt werden. Dabei wird insbesondere geprüft, ob die Timercharakteristik monoton und linear ist, um fehlerhafte Bauteile zu erkennen, falls die Timercharakteristik nicht monoton und/oder nicht linear ist.

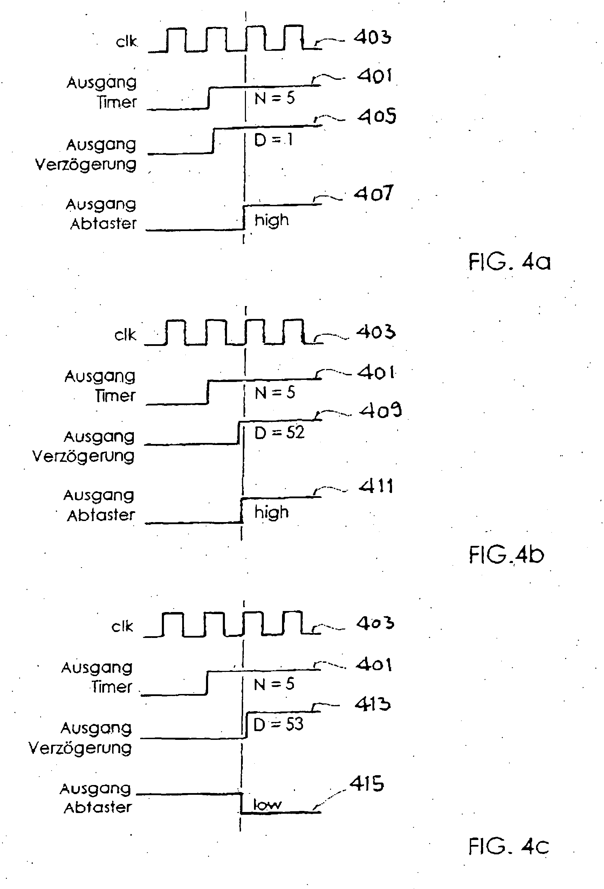

In den Figuren 4a, 4b und 4c sind weitere Signalzeitdiagramme dargestellt mit Timerausgangssignalen 401, Taktsignalen 403, einem. Ausgangssignal 405 der Verzögerungseinheit 203 für D(1) und einem Ausgangssignal 407 des Abtasters 205, einem Ausgangssignal 409 der Verzögerungseinheit 203 für D(53) und einem Ausgangssignal 411 des Abtasters 205 und einem Ausgangssignal 413 der Verzögerungseinheit 203 für D(53) und einem Ausgangssignal 415 des Abtasters 205.

### Bezugszeichenliste

- 101: Phasenverschiebungselement
- 103: Erfassungselement
- 201: Timer
- 203: Phasenverschiebungselement
- 205: Abtastelement
- 207: Kontrolleinheit
- 209: Interface
- 211: Tester
- 301: Timerausgangssignal
- 303: Timerausgangssignal
- 305: Taktsignal
- 401: Timerausgangssignal
- 403: Taktsignal
- 405: Ausgangssignal der Verzögerungseinheit
- 407: Ausgangssignal des Abtasters
- 409: Ausgangssignal der Verzögerungseinheit
- 411: Ausgangssignal des Abtasters
- 413: Ausgangssignal der Verzögerungseinheit
- 415: Ausgangssignal des Abtasters

## Patentansprüche

1. Vorrichtung zum Erfassen einer Zeitlage einer Flanke eines Signals relativ zu einer Zeitlage einer vorbestimmten Flanke eines periodischen Signals, wobei die Flanke einen Zustandswechsel zwischen einem ersten Zustand und einem zweiten Zustand des Signals festlegt und wobei die Vorrichtung folgende Merkmale aufweist:
- ein Phasenverschiebungselement (101) zum Verschieben der Phase des Signals relativ zu der Phase des periodischen Signals um einen Phasenverschiebungswert, bei dem der Zustandswechsel zu einem durch die Zeitlage der vorbestimmten Flanke festgelegten Zeitpunkt erfassbar ist; und
- ein Erfassungselement (103) zum Erfassen der Zeitlage der Flanke relativ zu der Zeitlage der vorbestimmten Flanke auf der Basis des Phasenverschiebungswertes;
wobei das Phasenverschiebungselement (101) ein einstellbares Verzögerungselement (203) zum Verzögern des Signals um einen einstellbaren Verzögerungswert als Phasenverschiebungswert ist.

2. Vorrichtung nach Anspruch 1, wobei das Verzögerungselement (203) Mittel zur Einstellung des Verzögerungswerts durch Steuerung in diskreten Schritten aufweist.

3. Vorrichtung nach Anspruch 2, wobei das Verzögerungselement (203) als Mittel schaltbare Kapazitäten aufweist.

4. Vorrichtung nach einem der Ansprüche 2 oder 3, wobei das Phasenverschiebungselement (101) ausgebildet ist, die Phase des Signals in einer Mehrzahl von diskreten Schritten mit jeweils einem pro Schritt vorbestimmten Verzögerungswert als Phasenverschiebungswert so lange zu verschieben, bis in einem durch die Zeitlage der vorbestimmten Flanke des periodischen Signals festgelegten Zeitpunkt der Zustandswechsel erfassbar ist.

5. Vorrichtung nach einem der vorhergehenden Ansprüche, mit einem Steuerelement (207), das ausgebildet ist, zur Einstellung des Verzögerungswertes die Verzögerung des Verzögerungselements (203) um einen vorbestimmten Verzögerungswert in Abhängigkeit von einem Ausgangssignal des Erfassungselements (103) zu verändern, insbesondere falls das Ausgangssignal des Erfassungselements (103) anzeigt, dass kein Zustandswechsel vorliegt.

6. Vorrichtung nach Anspruch 5, bei der das Steuerelement (207) zur Ermittlung und Ausgabe des Verzögerungswerts anhand der gesteuerten diskreten Schritte als erfasste Zeitlage der Flanke des Signals relativ zu der Zeitlage der vorbestimmten Flanke des periodischen Signals ausgebildet ist.

7. Vorrichtung nach einem der vorhergehenden Ansprüche, mit einem Timer, der ansprechend auf ein Steuersignal des Steuerelements (207), (als das Signal) ein Timersignal mit einer Timersignalflanke (als Flanke des Signals) ausgibt, die den Zustandswechsel zwischen einem ersten und einem zweiten Zustand des Timersignals festlegt,
wobei das Steuerelement (207) vorzugsweise ausgebildet ist das Steuersignal zu wiederholen und den Verzögerungswert mit jeder Wiederholung zu ändern bis vom Erfassungselement (103) ein Phasennulldurchgang als Abbruch-bedingung detektierbar ist.

8. Vorrichtung nach Anspruch 7, mit einem Analyseelement zum Erfassen der Charakteristik des Timers auf der Basis eines Verlaufs von Verzögerungswerten in Abhängigkeit von Zeitlagen.

9. Vorrichtung nach einem der vorhergehenden Ansprüche, wobei eine Differenz der Zeitlagen der Flanke und der vorbestimmten Flanke geringer als die Periodendauer des periodischen Signals ist.

10. Verfahren zum Erfassen einer Zeitlage einer Flanke eines Signals relativ zu einer Zeitlage einer vorbestimmten Flanke eines periodischen Signals, wobei die Flanke einen Zustandswechsel zwischen einem ersten Zustand und einem zweiten Zustand des Signals festlegt, und wobei das Verfahren folgende Schritte aufweist:
- Verschieben der Phase des Signals relativ zu der Phase des periodischen Signals um einen Phasenverschiebungswert durch Einstellen eines Verzögerungswerts eines Verzögerungselements, bei dem der Zustandswechsel zu einem durch die Zeitlage der vorbestimmten Flanke festgelegten Zeitpunkt erfassbar ist; und
- Erfassen der Zeitlage der Flanke relativ zu der Zeitlage der vorbestimmten Flanke auf der Basis des Verzögerungswerts als Phasenverschiebungswert.

11. Verfahren nach Anspruch 10, bei dem das Verschieben der Phase des Signals sooft wiederholt wird, bis ein Phasennulldurchgang als Abbruchbedingung erfasst wird.

12. Messverfahren zur Erfassung einer Charakteristik eines Timers, der ansprechend auf ein Steuersignal, das eine Zeitlage einer Flanke relativ zu einer Zeitlage einer vorbestimmten Flanke eines periodischen Signals anzeigt, ein Timersignal mit einer Timersignalflanke ausgibt, die einen Zustandswechsel zwischen einem ersten und einem zweiten Zustand des Timersignals festlegt, wobei das Messverfahren folgende Schritte aufweist:
- Bereitstellen eines ersten Steuersignals und eines zweiten Steuersignals, wobei das erste Steuersignal eine erste Flanke mit einer ersten Zeitlage relativ zu einer Zeitlage einer vorbestimmten Flanke eines periodischen Signals anzeigt und wobei das zweite Steuersignal eine zweite Flanke mit einer zweiten Zeitlage relativ zu einer Zeitlage einer vorbestimmten Flanke des periodischen Signals anzeigt;
- Verschieben der Phase eines ersten Timersignals mit einer ersten Timersignalflanke relativ zu der Phase des periodischen Signals um einen ersten Phasenverschiebungswert durch Einstellen eines ersten Verzögerungswerts eines Verzögerungselements, bei dem der Zustandswechsel zu einem durch die Zeitlage der vorbestimmten Flanke festgelegten Zeitpunkt erfassbar ist,
und Verschieben der Phase eines zweiten Timersignals mit einer zweiten Timersignalflanke relativ zu der Phase des periodischen Signals um einen zweiten Phasenverschiebungswert durch Einstellen eines zweiten Verzögerungswerts eines Verzögerungselements, bei dem der Zustandswechsel zu einem durch die Zeitlage der vorbestimmten Flanke festgelegten Zeitpunkt erfassbar ist,
- Erfassen der Zeitlage der ersten Timersignalflanke auf der Basis des ersten Verzögerungswerts als Phasenverschiebungswert und
- Erfassen der Zeitlage der zweiten Timersignalflanke auf der Basis des zweiten Verzögerungswerts als Phasenverschiebungswert;
- und Erfassen der Charakteristik auf der Basis eines Verlaufs von Phasenverschiebungswerten in Abhängigkeit von Zeitlagen.

13. Verwendung eines zusammen mit einem Timer auf einem Halbleiterchip integrierten einstellbaren Verzögerungselements (203), das ausgebildet ist ein (Timer-)Signal um einen einstellbaren Verzögerungswert zu verzögern, zur Erfassung einer Charakteristik des Timers, der ansprechend auf ein Steuersignal das Timersignal mit einer Timersignalflanke ausgibt, die einen Zustandswechsel zwischen einem ersten und einem zweiten Zustand des Timersignals festlegt.
